# EUROPÄISCHE PATENTSCHRIFT

(11) **EP 1 081 468 B1**
(45) Veröffentlichungstag und Bekanntmachung des Hinweises auf die Patenterteilung: **14.02.2007**
(21) Anmeldenummer: 00115605.8
(22) Anmeldetag: 20.07.2000
(51) Int. Cl.: G01F 23/24, G01F 25/00

(54) **Messwandler für Füllstandsensoren**
Transducer for level sensors
Transducteur pour détecteurs du niveau de remplissage

(30) Priorität: 28.08.1999 DE 19941023
(43) Veröffentlichungstag der Anmeldung: 07.03.2001
(73) Patentinhaber: GESTRA AG, 28215 Bremen (DE)
(72) Erfinder: Klattenhoff, Jürgen, 27749 Delmenhorst (DE); Schmitz, Günter, 26121 Oldenburg (DE); Schröter, Holger, 27321 Morsum (DE)
(74) Vertreter: Eisenführ, Speiser & Partner

(56) Entgegenhaltungen:
- DE-B- 2 531 915
- US-A- 3 910 118
- US-A- 4 322 713
- US-A- 4 761 638

## Beschreibung

Die Erfindung betrifft ein Steuergerät der im Oberbegriff des Hauptanspruches spezifizierten Art.

In Behältern, z. B. in Dampfkesseln, kann das Absinken des Füllstandes der elektrisch leitenden Flüssigkeit unter einen unteren Grenzwert zu gefährlichen Betriebszuständen führen. In solchen Anlagen muss daher der Füllstand der Flüssigkeit auf Grenzwertunterschreitung überwacht werden.

Für derartige sicherheitsrelevante Überwachungen des Füllstandes finden bevorzugt Füllstandsensoren mit einer Messelektrode und einer Kompensationselektrode Verwendung. Beide Elektroden wirken mit einer Gegenelektrode zusammen. Die Messelektrode dient der eigentlichen Überwachung des Füllstandes. Die Kompensationselektrode ist vorhanden, um fehlerhafte Signale zu unterbinden, die andernfalls durch sich eventuell bildende elektrisch leitende Niederschläge oder Belege auf den Füllstandsensoren verursacht werden könnten. Als Gegenelektrode kann beispielsweise ein die anderen beiden Elektroden mit Abstand umgebendes elektrisch leitendes Rohr vorgesehen sein (US PS 3 910 118). Es ist aber durchaus auch üblich, den elektrisch leitenden Behälter als Gegenelektrode fungieren zu lassen (DE PS 25 31 915). Die Füllstandsensoren sind zur Bildung des Füllstandsignals bei Grenzwertunterscheitung an Messwandler angeschlossen. Außerdem ist aus US 4,761,638 bekannt, einen Prüfschaltkreis mit einem Prüfschalter vorzusehen.

In einigen Einsatzfällen besteht die Forderung, die Messwandler selbstüberwachend auszubilden, siehe beispielsweise die "Technischen Regeln für Dampfkessel" (TRD 604). Die Messwandler sollen in vorgegebenen Zeitabständen selbsttätig ihre Fähigkeit prüfen, bei auftretender Grenzwertunterschreitung zuverlässig das entsprechende Alarmsignal geben zu können.

Der Erfindung liegt die Aufgabe zugrunde, einen Messwandler der eingangs genannte Art zu schaffen, in dem solche Selbstüberwachung erfolgt.

Diese Aufgabe wird durch die im Anspruch 1 angegebenen Merkmale gelöst.

Während der Überwachung des Füllstandes im Behälter ist der Prüfschalter geschlossen, also auf Durchgang geschaltet. Der sich im Behälter ausbildende Messwiderstand sowie der Kompensationswiderstand bestimmen die Brückenverstimmung und damit das Ausgangssignal des Messwandlers. Bei einer Grenzwertunterschreitung gibt der Messwandler ein entsprechendes Füllstandsignal aus. Liegt der Füllstand oberhalb des Grenzwertes, wird dies vom Messwandler signalisiert. Zu vorgegebenen Zeitpunkten prüft der Messwandler seine Funktionsfähigkeit darauf, ob im Falle einer Grenzwertunterschreitung des Füllstandes ein entsprechendes Füllstandsignal erzeugt werden könnte. Hierzu wird der Prüfschalter geöffnet. Der Messwiderstand und der Kompensationswiderstand sind dann für die Brückenverstimmung nicht von Bedeutung. Sie wird vielmehr durch die beiden Prüfwiderstände bestimmt, die den Zustand "Grenzwertunterschreitung" simulieren. Bei der Prüfung muss in der Auswerteeinrichtung das Füllstandsignal "Flüssigkeitsmangel" gebildet werden können. Ist dies nicht der Fall, liegt ein Fehler vor und der Messwandler gibt ein entsprechendes Fehlersignal aus. Die Prüfung ist unabhängig von der Leitfähigkeit der Flüssigkeit im Behälter.

Die Merkmale des Anspruches 2 wirken sich sehr vorteilhaft auf die Generierung eines ausgeprägten Füllstandsignals aus. Die Merkmalen des Anspruches 3 bewirken eine besonders starke Verstimmung der Brückenschaltung, wenn die Messelektrode in die Flüssigkeit eingetaucht ist. Diese starke Verstimmung ist entgegengesetzt zu der durch die Prüfwiderstände definierten Brückenverstimmung. Die Signalbildung ist unabhängig von eventuellen Schwankungen oder Unterschieden der Versorgungsspannung des Messwandlers.

Die Weiterbildung des Messwandlers nach Anspruch 4 weist eine besonders vorteilhafte Ermittlung der Brückenverstimmung und der Signalbildung auf. Das gewonnene Signal ist unabhängig von eventuellen Schwankungen in der Speisespannung der Mess-Schaltung. Die Signalbildung mit digitalen Mitteln wird gleichfalls erleichtert.

Die Steuerung der Prüfungen sowie die Signalbildung lässt sich besonders vorteilhaft entsprechend Anspruch 5 realisieren.

Ein Ausführungsbeispiel der Erfindung ist in der Zeichnung schematisiert dargestellt und wird im Folgenden näher beschrieben. Es zeigt
- Fig. 1: den Messwandler, der an den Füllstandsensor eines Behälters angeschlossen ist und
- Fig. 2: den Messwandler in detaillierterer Darstellung.

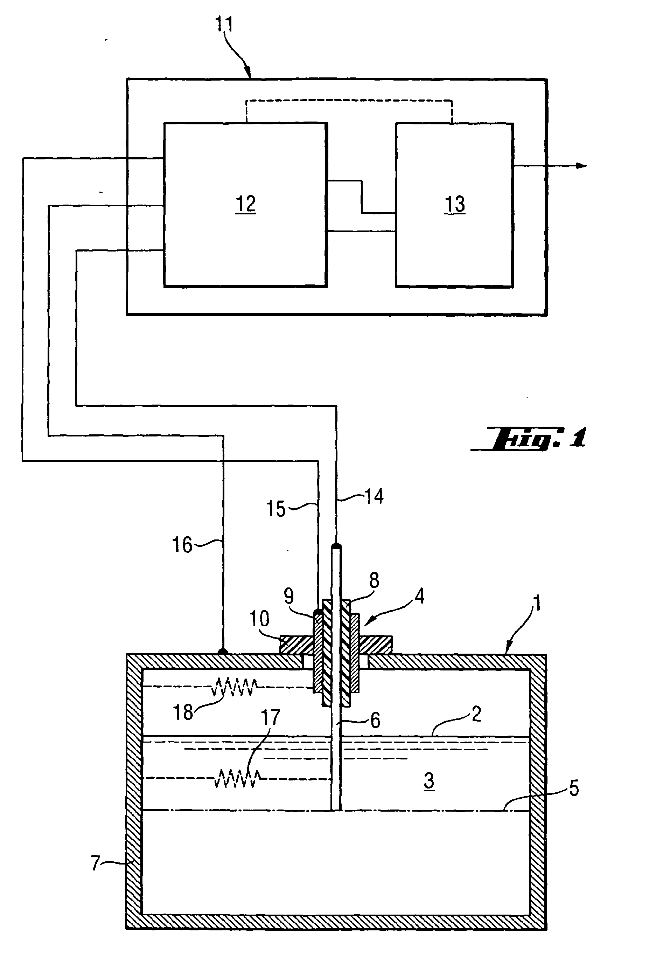

Fig. 1 zeigt einen Behälter 1, in dem der Füllstand 2 einer darin befindlichen elektrisch leitenden Flüssigkeit 3 mit einem Füllstandsensor 4 überwacht werden soll. Der Füllstandsensor 4 weist eine im Behälter 1 bis zu einem vorgegebenen unteren Grenzwert 5 hinabreichende Messelektrode 6 auf. Im Bereich der Behälterwand 7 ist die Messelektrode 6 von einer Isolation 8 umgeben, die wiederum von einer Kompensationselektrode 9 umgeben ist. Die Kompensationselektrode 9 ist zum einen durch die Isolation 8 elektrisch gegen die Messelektrode 6 und zum anderen durch eine weitere Isolation 10 gegen die Behälterwand 7 elektrisch isoliert.

Ein elektronischer Messwandler 11 weist eine Mess-Schaltung 12 und eine Auswerteeinrichtung 13 auf. Die Mess-Schaltung 12 ist über eine erste Leitung 14 mit der Messelektrode 6 und über eine zweite Leitung 15 mit der Kompensationselektrode 9 des Füllstandsensors 4 elektrisch leitend verbunden. Die Behälterwand 7 fungiert als Gegenelektrode für die Messelektrode 6 und die Kompensationselektrode 9. Sie ist zu diese Zweck über eine dritte Leitung 16 an die Mess-Schaltung 12 angeschlossen.

Entsprechend dem umgebenden Medium - Flüssigkeit oder gasförmiges Medium - bildet sich zwischen der Messelektrode 6 und der Behälterwand 7 ein elektrischer Messwiderstand 17 und zwischen der Kompensationselektrode 9 und der Behälterwand 7 ein Kompensationswiderstand 18 aus. In Fig. 1 sind sie symbolisch in Strichellinie dargestellt.

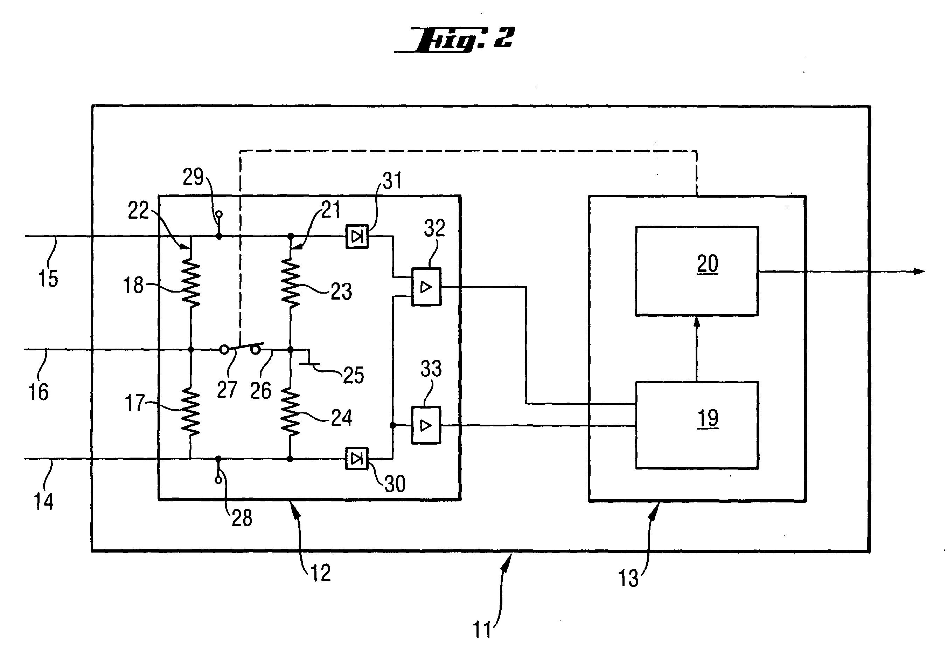

Die Auswerteeinrichtung 13 weist einen Analog-Digital-Wandler 19 und einen Mikroprozessor 20 auf (Fig. 2). Die Mess-Schaltung 12 weist eine Brückenschaltung mit zwei Brückenzweigen 21, 22 auf. Im ersten Brückenzweig 21 sind zwei Prüfwiderstände 23, 24 in Reihe geschaltet. Die Verbindung zwischen den beiden Prüfwiderständen 23, 24 ist mit dem Grundpotential 25 der Mess-Schaltung 12 verbunden. Die Leitungen 14, 15, 16 sind derart an die Mess-Schaltung 12 angeschlossen, dass der Messwiderstand 17 und der Kompensationswiderstand 18 in Reihe geschaltet sind und gemeinsam den zweiten Brückenzweig 22 bilden. Beide Brückenzweige 21, 22 sind an den Verbindungen ihrer beiden Widerstände 17, 18; 23, 24, also mittig über eine Diagonalleitung 26 miteinander verbunden, in der ein von der Auswerteeinrichtung 13 betätigter Prüfschalter 27 vorgesehen ist. Beide Brückenzweige 21, 22 sind außerdem an ihren Enden miteinander und über Versorgungsleitungen 28, 29 an eine nicht dargestellte Wechselspannungsquelle angeschlossen. An beide Enden des ersten Brückenzweiges 21 ist jeweils ein Gleichrichterglied 30, 31 angeschlossen. Jedes Gleichrichterglied 30, 31 misst die Brückenteilspannung zwischen dem jeweiligen Ende des Brückenzweiges 21 und dem Grundpotential 25 und bildet eine entsprechende Gleichspannung. Die Gleichspannungen beider Gleichrichterglieder 30, 31 werden in einem als Summierglied nachgeschalteten ersten Operationsverstärker 32 addiert und verstärkt. Die Gleichspannung des Gleichrichtergliedes 30, das mit dem dem Messwiderstand 17 benachbarten Ende des Brückenzweiges 21 verbunden ist, wird separat in einem zweiten Operationsverstärker 33 verstärkt, und zwar um den gleichen Faktor wie die andere Gleichspannung.

Die Oberfläche der Messelektrode 6 innerhalb des Behälters 1 ist deutlich größer ausgebildet als die Oberfläche der Kompensationselektrode 9. Daher ist der Kompensationswiderstand 18 deutlich größer als der Messwiderstand 17. Dies gilt, wenn die Messelektrode 6 allein in die Flüssigkeit 3 eingetaucht ist, aber auch, wenn zusätzlich die Kompensationselektrode 9 in die Flüssigkeit 3 eingetaucht sein sollte oder sie elektrisch leitende Beläge/Niederschläge aufweist. Die Flüssigkeit 3 im Behälter 1 weist eine wesentlich größere elektrische Leitfähigkeit auf als das darüber befindliche gasförmige Medium, z. B. Luft oder Wasserdampf.

Die Widerstandswerte der beiden Prüfwiderstände 23, 24 stehen in einem Verhältnis zueinander, das kleiner ist als das Verhältnis der Widerstandswerte des Messwiderstandes 17 und des Kompensationswiderstandes 18. Dies bezieht sich auf deren Verhältnis, wenn sowohl die Messelektrode 6 als auch die Kompensationselektrode 9 in die Flüssigkeit 3 eingetaucht ist. Im ersten Brückenzweig 21 ist die Reihenfolge höherer/niedrigerer Widerstandswert allerdings konträr zur Reihenfolge der Widerstandswerte im zweiten Brückenzweig 22. Im diesem weist, wie bereits erwähnt, der Messwiderstand 17 den niedrigeren Wert und der Kompensationswiderstand 18 den höheren Wert auf. Im ersten Brückenzweig 21 weist hingegen der zum Messwiderstand 17 parallele Prüfwiderstand 24 den höheren Widerstandswert beider Prüfwiderstände 23, 24 auf. Mit anderen Worten: Der Prüfwiderstand 24 ist um einen Faktor größer als der Prüfwiderstand 23, der kleiner ist als der Faktor, um den der Kompensationswiderstand 18 größer ist als der Messwiderstand 17.

Der Füllstand 2 im Behälter 1 soll darauf überwacht werden, ob er den vorgegebenen unteren Grenzwert 5 unterschreitet. Zur Überwachung des Füllstandes 2 wird der Prüfschalter 27 von der Auswerteeinrichtung 13 geschlossen, gesteuert durch den Mikroprozessor 20. Befindet sich der Füllstand 2 oberhalb des Grenzwertes 5, ist der sich zwischen der Messelektrode 6 und der Behälterwand 7 ausbildende Messwiderstand 17 kleiner als der sich zwischen der Kompensationselektrode 9 und der Behälterwand 7 ausbildende Kompensationswiderstand 18. Im übrigen ist der Messwiderstand 17 auch um so viel kleiner als die Prüfwiderstände 23, 24 und das Verhältnis von Messwiderstand 17 zu Kompensationswiderstand 18 um so viel größer als das Verhältnis der Prüfwiderstände 23, 24, dass der zweite Brückenzweig 22 bei der Brückenverstimmung dominiert. Er verursacht eine Brückenverstimmung, mit einer niedrigen Brückenteilspannung am Gleichrichterglied 30 und einer hohen Brückenteilspannung am Gleichrichterglied 31. Von den Gleichrichtergliedem 30, 31 gelangen entsprechende Spannungssignale über die Operationsverstärker 32, 33 in die Auswerteeinheit 13. In dem Analog-Digital-Wandler 19 werden aus den analogen Spannungssignalen der Mess-Schaltung 12 Digitalwerte gebildet, aus denen der Mikroprozessor 20 ein Füllstandsignal "Füllstand ausreichend" bildet. Hierzu wird die durch den Operationsverstärker 32 gebildete Summe beider Teilspannungen durch das aus dem Operationsverstärker 33 erhaltene Spannungssignal dividiert. Eventuelle Schwankungen der über die Versorgungsleitungen 28, 29 eingespeisten Versorgungsspannung beeinflussen die Signalbildung nicht.

Unterschreitet der Füllstand 2 im Behälter 1 den Grenzwert 5, dann ist die Messelektrode 6 aus der Flüssigkeit 3 ausgetaucht. Der Messwiderstand 17 und der Kompensationswiderstand 18 nehmen folglich beide sehr hohe Widerstandswerte an. Sie liegen so weit über denen der Prüfwiderstände 23, 24, dass jetzt der erste Brückenzweig 21 dominiert. Da der Prüfwiderstand 23 den niedrigeren und der Prüfwiderstand 24 den höheren Widerstandswert aufweist, bewirkt der Brückenzweig 21 eine entgegengesetzte Brückenverstimmung. Die an das Gleichrichterglied 30 gelangende Brückenteilspannung ist dann höher als die am Gleichrichterglied 31 anliegende. Die Auswerteeinrichtung 13 gibt daraufhin das Füllstandsignal "Flüssigkeitsmangel".

Periodisch prüft der Messwandler 11 selbsttätig seine Funktionsfähigkeit darauf, ob im Falle einer Grenzwertunterschreitung des Füllstandes 2 zuverlässig das entsprechende Füllstandsignal gegeben werden kann. Die Prüfung erfolgt, solange der Füllstand 2 den Grenzwert 5 nicht unterschreitet, also keine Grenzwertunterschreitung vorliegt. Diese Bedingung prüft die Auswerteeinrichtung 13 über den Mikroprozessor 20 vor der Funktionsprüfung.

Zur Funktionsprüfung wird der Prüfschalter 27 von der Auswerteeinrichtung 13 so angesteuert, dass er von der Stellung "Schalter geschlossen" für eine vorgegebene Prüfdauer in die Stellung "Schalter offen" umschaltet. Während der erfolgten Unterbrechung der Diagonalleitung 26 hat der zweite Brückenzweig 22 keinen Einfluss auf die Brückenverstimmung. Diese wird während der Prüfung einzig von dem ersten Brückenzweig 21 bestimmt. Wie zuvor angegeben, simuliert der erste Brückenzweig 21 den Zustand "Grenzwertunterschreitung" und führt dementsprechend zu einer höheren Brückenteilspannung am Gleichrichterglied 30 und einer geringeren am Gleichrichterglied 31. Die von dort via Operationsverstärker 32, 33 in die Auswerteeinrichtung 13 gelangenden Spannungssignale werden vom Mikroprozessor 20 ausgewertet. Führt die Auswertung intern in der Auswerteeinrichtung 13 zu dem adäquaten Füllstandsignal "Flüssigkeitsmangel", wird nach Ende der Prüfdauer der Prüfschalter 27 von der Auswerteeinrichtung 13 so angesteuert, dass er wieder schließt und die Überwachung des Füllstandes 2 fortgesetzt wird. Ein Füllstandsignal "Flüssigkeitsmangel" wird im Zuge der kurzzeitigen Prüfung von der Auswerteeinrichtung 13 nicht ausgegeben. Kommt es allerdings während der Prüfung in der Auswerteeinrichtung 13 nicht zu dem Füllstandsignal Flüssigkeitsmangel", liegt ein Fehler in dem Messwandler 11 vor und die Auswerteeinrichtung 13 gibt ein Fehlersignal aus. Eventuelle sicherheitsrelevante Funktionsfehler des Messwandlers 11 werden auf diese Weise erkannt.

### Bezugszeichenliste:

- 1: Behälter
- 2: Füllstand
- 3: Flüssigkeit
- 4: Füllstandsensor
- 5: Grenzwert
- 6: Messelektrode
- 7: Behälterwand
- 8: Isolation
- 9: Kompensationselektrode
- 10: Isolation
- 11: Messwandler
- 12: Mess-Schaltung
- 13: Auswerteeinrichtung
- 14: Leitung
- 15: Leitung
- 16: Leitung
- 17: Messwiderstand
- 18: Kompensationswiderstand
- 19: Analog-Digital-Wandler
- 20: Mikroprozessor
- 21: Brückenzweig
- 22: Brückenzweig
- 23: Prüfwiderstand
- 24: Prüfwiderstand
- 25: Grundpotential
- 26: Diagonalleitung
- 27: Prüfschalter
- 28: Versorgungsleitung
- 29: Versorgungsleitung
- 30: Gleichrichterglied
- 31: Gleichrichterglied
- 32: Operationsverstärker
- 33: Operationsverstärker

## Patentansprüche

1. Messwandler für Füllstandsensoren, die eine Messelektrode (6) und eine Kompensationselektrode (9) aufweisen, die zur Überwachung von Grenzwertunterschreitungen des Füllstandes (2) einer elektrisch leitenden Flüssigkeit (3) beide mit einer Gegenelektrode (7) zusammenwirken, mit
• einer Mess-Schaltung (12) für den Anschluss der Messelektrode (6), der Kompensationselektrode (9) und der Gegenelektrode (7) und
• einer an die Mess-Schaltung (12) angeschlossenen Auswerteeinrichtung (13) zur Bildung eines Alarmsignals bei Grenzwertunterschreitung, wobei
• die Mess-Schaltung (12) zwei in Reihe geschaltete Prüfwiderstände (23, 24) aufweist, die einen ersten Zweig einer Brückenschaltung (21) bilden, und
• die Messelektrode(6), die Kompensationselektrode (9) und die Gegenelektrode (7) so an die Mess-Schaltung (12) angeschlossen sind, dass der sich zwischen der Messelektrode (6) und der Gegenelektrode (7) entsprechend dem Füllstand (2) der elektrisch leitenden Flüssigkeit (3) ausbildende elektrische Messwiderstand (17) mit dem sich zwischen der Kompensationselektrode (9) und der Gegenelektrode (7) ausbildenden elektrischen Kompensationswiderstand (18) in Reihe geschaltet ist und diese beiden Widerstände (17, 18) gemeinsam den zweiten Zweig der Brückenschaltung (22) bilden,
**dadurch gekennzeichnet, dass**
• an beiden Enden des ersten Brückenzweiges (21) jeweils ein Gleichrichterglied (30, 31) angeschlossen ist, wobei jedes Gleichrichterglied (30, 31) die Brückenteilspannung zwischen dem jeweiligen Ende des ersten Brückenzweiges (21) und dem Grundpotential (25) misst und eine entsprechende Gleichspannung bildet,
• zwischen den beiden Brückenzweigen (21, 22) eine Diagonalleitung (26) mit einem Prüfschalter (27) vorgesehen ist,
• Steuerungsmittel (13) für den Prüfschalter (27) vorgesehen sind, die außerhalb vorgegebener Prüfzeiten den Prüfschalter (27) schließen und ihn zu vorgegebenen Prüfzeiten öffnen,
• das zwischen beiden Prüfwiderständen (23, 24) gelegene Ende der Diagonalleitung (26) mit dem Grundpotential (25) der Messschaltung (12) verbunden ist,
• die Widerstände (17, 18, 23, 24) der Brückenschaltung so ausgebildet sind, dass bei geschlossenem Prüfschalter (27) die signalbestimmende Brückenverstimmung der Messbrücke durch zweiten Brückenzweig (22) bestimmt wird, während bei geöffnetem Prüfschalter (27) die Brückenverstimmung durch ersten Brückenzweig (21) bestimmt und eine Grenzwertunterschreitung simuliert wird, wobei die Auswerteeinrichtung (13) bei nicht entsprechendem Signal der Mess-Schaltung (12) ein Fehlersignal gibt.

2. Messwandler nach Anspruch 1, **dadurch gekennzeichnet, dass**
• die Prüfwiderstände (23, 24) im ersten Brückenzweig (21) so gestaltet sind, dass ihre Widerstandswerte in einem Verhältnis stehen, das kleiner ist als das Verhältnis der Widerstandswerte des Messwiderstandes (17) und des Kompensationswiderstandes (18), wenn die Messelektrode (6) und die Kompensationselektrode (9) beide in die Flüssigkeit (3) eingetaucht sind, und
• die Reihenfolge des höherer und des niedrigerer Widerstandswertes in beiden Brückenzweigen (21, 22) konträr ist.

3. Messwandler nach Anspruch 2, **dadurch gekennzeichnet, dass**
• der eine Prüfwiderstand (23) einen höheren Widerstandswert aufweist als der Messwiderstand (17) bei eingetauchter Messelektrode (6),
• der andere Prüfwiderstand (24) einen höheren Widerstandswert aufweist als der Kompensationswiderstand (18) bei eingetauchter Kompensationselektrode (9) und
• die Widerstandswerte der Prüfwiderstände (23, 24) um so viel höher sind, dass bei in die Flüssigkeit (3) eingetauchter Messelektrode (6) der zweite Brückenzweig (22) die Brückenverstimmung der Messbrücke dominiert.

4. Messwandler nach einem oder mehreren der vorhergehenden Ansprüche, **dadurch gekennzeichnet, dass**
• beide Brückenzweige (21,22) an ihren benachbarten Enden miteinander verbunden sind,
• Mittel (30) zur Messung einer ersten Brückenteilspannung zwischen dem Grundpotential (25) und der einen endseitigen Verbindung beider Brückenzweige (21, 22) vorgesehen sind,
• Mittel (31) zur Messung einer zweiten Brückenteilspannung zwischen dem Grundpotential (25) und der anderen endseitigen Verbindung beider Brückenzweige (21, 22) vorgesehen sind,
• ein Summierglied (32) vorgesehen ist, das beide Brückenteilspannungen summiert, und
• die Auswerteeinrichtung (13) zur Signalbildung die Summe beider Brückenteilspannungen durch die an dem dem Messwiderstand (17) nahen Ende gemessene Brückenteilspannung dividiert.

5. Messwandler nach einem oder mehreren der vorhergehenden Ansprüche, **dadurch gekennzeichnet, dass** die Auswerteeinrichtung (13) einen Analog-Digital-Wandler (19) für die eingehenden Signalspannungen der Mess-Schaltung (12) und einen Mikroprozessor (20) zur Steuerung des Prüfschalters (20) und zur Signalbildung aufweiset.

## Claims

1. Measurement transducer for fill level sensors having a measuring electrode (6) and a compensating electrode (9) which both cooperate with a counter electrode (7) to monitor conditions in which the fill level (2) of an electrically conductive liquid (3) drops below a limit value, with a measuring circuit (12) for connecting the measuring electrode (6), the compensating electrode (9) and the counter electrode (7) and an evaluation device (13) connected to the measuring circuit (12) to produce an alarm signal if the fill level drops below a limit value, the measuring circuit (12) comprising two test resistors (23, 24) which are connected in series and form a first branch of a bridge circuit (21), and the measuring electrode (6), the compensating electrode (9) and the counter electrode (7) being connected to the measuring circuit (12) so that an electrical measuring resistor (17) formed between the measuring electrode (6) and the counter electrode (7) according to the fill level (2) of the electrically conductive liquid (3) is connected in series with an electrical compensating resistor (18) formed between the compensating electrode (9) and the counter electrode (7), and these two resistors (17, 18) together forming the second branch of the bridge circuit (22), **characterised in that** a respective rectifier component (30, 31) is connected at each end of the first bridge branch (21), each rectifier component (30, 31) measuring the partial bridge voltage between the respective end of the first bridge branch (21) and the base potential (25) and forming a corresponding dc voltage, a diagonal line (26) comprising a test switch (27) is provided between the two bridge branches (21, 22), control means (13) are provided for the test switch (27) which close the test switch (27) outside preset test times and open it at preset test times, the end of the diagonal line (26) between the two test resistors (23, 24) is connected to the base potential (25) of the measuring circuit (12), the resistors (17, 18, 23, 24) of the bridge circuit are configured so that when the test switch (27) is closed, the second bridge branch (22) determines the signal-determining unbalancing of the measuring bridge, and when the test switch (27) is open, the first bridge branch (21) determines the bridge unbalancing and a situation in which the fill level drops below the limit value is simulated, the evaluation device (13) transmitting an error signal when there is no corresponding signal from the measuring circuit (12).

2. Measurement transducer according to claim 1, **characterised in that** the test resistors (23, 24) are configured in the first bridge branch (21) so that their resistance values have a ratio with respect to each other which is smaller than the ratio of the resistance values of the measuring resistor (17) and the compensating resistor (18) if the measuring electrode (6) and the compensating electrode (9) are both immersed in the liquid (3) and the sequence of the higher and lower resistance value is the opposite in the two bridge branches (21,22).

3. Measurement transducer according to claim 2, **characterised in that** one test resistor (23) has a higher resistance value than the measuring resistor (17) when the measuring electrode (6) is immersed, the other test resistor (24) has a higher resistance value than the compensating resistor (18) when the compensating electrode (9) is immersed, and the resistance values of the test resistors (23, 24) are sufficiently higher so that when the measuring electrode (6) is immersed in the liquid (3), the second bridge branch (22) dominates the unbalancing of the measuring bridge.

4. Measurement transducer according to one or more of the preceding claims, **characterised in that** the two bridge branches (21, 22) are connected to each other at their adjacent ends, means (30) are provided for measuring a first partial bridge voltage between the base potential (25) and one end connection of both bridge branches (21, 22), means (31) are provided for measuring a second partial bridge voltage between the base potential (25) and the other end connection of both bridge branches (21, 22), a summing member (32) is provided for adding up the two partial bridge voltages, and the evaluation device (13) divides the sum of the two partial bridge voltages by the partial bridge voltage measured at the end close to the measuring resistor (17), to produce the signal.

5. Measurement transducer according to one or more of the preceding claims, **characterised in that** the evaluation device (13) comprises an analog-digital-converter (19) for the incoming signal voltages of the measuring circuit (12) and a microprocessor (20) for controlling the test switch (20) and for producing the signal.

## Revendications

1. Transducteur pour des capteurs du niveau de remplissage, qui comportent une électrode de mesure (6) et une électrode de compensation (9), qui coopèrent toutes deux avec une contre-électrode pour la surveillance de non-atteinte d'une valeur limite par le niveau de remplissage (2) d'un liquide (3) conducteur électrique, avec
• un circuit de mesure (12) pour le branchement de l'électrode de mesure (6), de l'électrode de compensation (9) et de la contre-électrode (7) et
• un dispositif d'évaluation (13) branché sur le circuit de mesure (12) pour la création d'un signal d'alarme en cas de non atteinte de la valeur limite,
• le circuit de mesure (12) comportant deux résistances de contrôle (23, 24) qui forment une première branche d'un circuit en pont (21), et
• l'électrode de mesure (6), l'électrode de compensation (9) et la contre-électrode (7) étant branchées sur le circuit de mesure (12) de façon telle, que la résistance de mesure (17) électrique se créant entre l'électrode de mesure (6) et la contre-électrode (7) en fonction du niveau de remplissage (2) du liquide (3) conducteur électrique soit montée en série avec la résistance de compensation (18) électrique se créant entre l'électrode de compensation (9) et la contre-électrode (7) et ces deux résistances (17, 18) forment ensemble la deuxième branche du circuit en pont (22)
**caractérisé en ce que**
• sur chacune des deux extrémités de la première branche du pont (21) est branché un élément redresseur (30, 31), chaque élément redresseur (30, 31) mesurant la tension partielle de pont entre l'extrémité respective de la première branche de pont (21) et le potentiel de base (25) et créant une tension continue correspondante,
• entre les deux branches de pont (21, 22) est prévue une ligne diagonale (26) avec un commutateur de contrôle (27),
• des moyens de commande (13), qui hors des heures de contrôle prédéfinies ferment le commutateur de contrôle (27) et qui l'ouvrent à des heures de contrôle prédéfinies sont prévus pour le commutateur de contrôle (27),
• l'extrémité de la ligne diagonale (26) située entre les deux résistances de contrôle (23, 24) est reliée au potentiel de base (25) du circuit de mesure (12),
• les résistances (17, 18, 23, 24) du circuit en pont sont conçues de façon telle, que lorsque le commutateur de contrôle (27) est fermé, le désaccord de fréquence en pont du pont de mesure déterminant les signaux est déterminé par la deuxième branche du pont (22), alors que lorsque le commutateur de contrôle (27) est ouvert, le désaccord de fréquence en pont est déterminé par la première branche du pont (21) et une non atteinte de la valeur limite est simulée, le dispositif d'évaluation (13) délivrant un signal d'erreur à défaut d'un signal correspondant du circuit de mesure (12).

2. Transducteur selon la revendication 1, **caractérisé en ce que**
• les résistances de contrôle (23, 24) dans la première branche de pont (21) sont conçues de façon telle, que leurs valeurs de résistance sont en un rapport qui est inférieur au rapport entre les valeurs de résistance de la résistance de mesure (17) et de la résistance de compensation (18), lorsque l'électrode de mesure (6) et l'électrode de compensation (9) sont toutes deux immergées dans le liquide (3).
• le séquence de la valeur de résistance la plus élevée et la plus basse est contraire dans les deux branches de pont (21, 22).

3. Transducteur selon la revendication 2, **caractérisé en ce que**
• l'une des résistances de contrôle (23) présente une valeur de résistance plus élevée que la résistance de mesure (17), lorsque l'électrode de mesure (6) est immergée,
• l'autre résistance de contrôle (24) présente une valeur de résistance plus élevée que la résistance de compensation (18), lorsque l'électrode de compensation (9) est immergée, et
• les valeurs de résistance des résistances de contrôle (23, 24) sont plus élevées de la valeur de laquelle la deuxième branche de pont (22) domine le désaccord de fréquence du pont de mesure, lorsque l'électrode de mesure (6) est immergée dans le liquide (3).

4. Transducteur selon l'une quelconque ou plusieurs des revendications précédentes, **caractérisé en ce que**,
• les deux branches de pont (21,22) sont reliées entre elles par leurs extrémités voisines,
• des moyens (30) sont prévus pour mesurer une première tension partielle de pont entre le potentiel de base (25) et l'une des liaisons côté extrémité des deux branches de pont (21, 22),
• des moyens (31) sont prévus pour mesurer une deuxième tension partielle de pont entre le potentiel de base (25) et l'autre des liaisons côté extrémité des deux branches de pont (21, 22),
• un totalisateur (32) est prévu pour totaliser les deux tensions partielles de pont et
• pour la création du signal, le dispositif d'évaluation (13) divise la somme des deux tensions partielles de pont par la tension partielle de pont mesurée sur l'extrémité proche de la résistance de mesure (17).

5. Transducteur selon l'une quelconque ou plusieurs des revendications précédentes, **caractérisé en ce que** dispositif d'évaluation (13) comporte un convertisseur analogique/numérique (19) pour les tensions de signaux entrantes du circuit de mesure (12) et un microprocesseur (20) pour commander le commutateur de contrôle (27) et pour créer le signal.
